# EUROPÄISCHE PATENTSCHRIFT

(11) **EP 2 416 637 B1**
(45) Veröffentlichungstag und Bekanntmachung des Hinweises auf die Patenterteilung: **16.03.2016**
(21) Anmeldenummer: 10075338.3
(22) Anmeldetag: 05.08.2010
(51) Int. Cl.: H05K 7/20, H04B 1/036

(54) **Vorrichtung und Verfahren zur Kühlung gehauster Räume**
Device and method for cooling residential rooms
Dispositif et procédé de refroidissement de pièces abritées

(43) Veröffentlichungstag der Anmeldung: 08.02.2012
(73) Patentinhaber: Ventfair GmbH, 12099 Berlin (DE); CSR Building Products Limited, North Ryde NSW 2113 (AU)
(72) Erfinder: Skrobek Norbert, 16565 Lehnitz (DE); Alfakhrany, Tarek, North Ryde, NSW 2113 (AU); Munn, Derek, North Ryde, NSW 2113 (AU)
(74) Vertreter: Kietzmann, Manfred

(56) Entgegenhaltungen:
- EP-A1- 1 988 760
- WO-A1-2005/034599
- WO-A1-2006/079855
- GB-A- 2 202 681
- US-A- 6 131 647

## Beschreibung

Die Erfindung betrifft ein Kühlsystem für gehauste Räume, insbesondere von mit Elektronikschränken bestückte Telekommunikationseinrichtungen in Form von Containern und beschreibt ihren Betrieb.

Derartige Container, die vielfältig beim Betrieb von Sendemasten für Mobilfunktechnik eingesetzt werden, nutzen zu Kühlungszwecken Klimaanlagen, was nicht nur energieintensiv, sondern auch mit einem CO₂ Ausstoß verbunden ist.

In der EP 1 988 760 A1 wird eine Temperaturkontrolleinrichtung für einen gehausten Raum außerhalb eines schützenden Gebäudes beschrieben, in dem elektronische Baueinheiten angeordnet sind.

Durch eine gezielte Lufteinleitung, Zirkulation und Luftauslässe sollen eine optimale Arbeitstemperatur und relative Luftfeuchtigkeit für die elektronischen Baueinheiten gewährleistet und Feuchtigkeitskondensationen verhindert werden.

Sowohl im Bereich der Lufteinlässe als auch der Lufteinlässe sowie auch innerhalb des gehausten Raumes werden dafür Lüfter und eine Heizeinrichtung eingesetzt, die in Abhängigkeit von den ermittelten Temperaturen über eine Steuereinrichtung ansteuerbar sind.

Der in der WO 2005/034599 A1 beschriebene Container für elektronische Bauteile, die Wärme abgeben, findet bei Telekommunikationsanlagen Verwendung. Der Container ist in einen inneren und einen äußeren gehausten Raum unterteilt, wobei in den Zwischenraum über Lüftungsschlitze Luft von außen ein- und nach außen ausströmen kann. Die elektronischen Bauteile befinden sich im inneren Raum, der über eine Klimaanlage verfügt. Eine zweite Klimaanlage ist in der Zwischenwand zwischen dem inneren und dem äußeren gehausten Raum angeordnet.

Neben Klimaanlagen ist aus der DE 20 2008 016 601 U1 eine Vorrichtung zur Kühlung gehauster Räume bekannt, die aus einem Gehäuse besteht, das über einen Zuluftkanal zum und über einen Abluftkanal aus dem gehausten Raum mit diesem verbunden ist und das Gehäuse über mindestens einen Luftansaugkanal für Umgebungsluft und über mindestens einen Luftaustrittskanal in die Umgebungluft verfügt, wobei der oder die Luftansaugkanäle in das Gehäuse und der Zuluftkanal zum gehausten Raum miteinander unter Zwischenschaltung eines Lüfters verbunden sind und der Abluftkanal aus dem gehausten Raum mit den oder den Luftaustrittskanälen aus dem Gehäuse miteinander verbunden sind und mindestens im Luftansaugkanal in das Gehäuse ein Luftfilter angeordnet ist.

Aus der WO 2006/079865 ist eine andere Vorrichtung zur Kühlung gehauster Räume bekannt.

Vorteilhafterweise erfolgt auch die Verbindung des Abluftkanals aus dem gehausten Raum mit dem oder den Luftkanälen aus dem Gehäuse unter Zwischenschaltung eines Lüfters.

Nachteilig bei dieser Lösung ist, dass der Luftaustausch zu Kühlzwecken ausschließlich durch elektrische Lüfter betrieben wird.

Weiter sind Rotorventilatoren zur Raumbelüftung bekannt. Eine solche Hybridturbine wird in der EP 1 360 442 B1 beschrieben und ist am Markt unter der Marke ecopower (eingetragene Marke der australischen Firma Edmonds) bekannt. Dabei handelt es sich um einen Lamellendachventilator.

Aufgabe der Erfindung ist es, insbesondere für autark aufgestellte Container sowohl eine Alternativlösung zu Klimaanlagen vorzuschlagen als auch eine Kombinationslösung mit vorhandenen Kühleinrichtungen, wobei der Energieverbrauch der Einrichtung auf ein Minimum gesenkt werden soll, u. a. durch den Einsatz vorgenannter Hybridturbinen.

Gelöst wird diese Aufgabe mit den Merkmalen des Vorrichtungsanspruches 1 und des Verfahrensanspruches 6, vorteilhafte Ausgestaltungen sind Gegenstand der Unteransprüche.

Die erfindungsgemäße Vorrichtung zum Kühlen von gehausten Räumen, insbesondere von Telekommunikationsanlagen, die in Containern angeordnet sind, sieht vor einen verschließbaren Zuluftkanal für Umgebungsluft in den Container, einen verschließbaren Abluftkanal aus dem Container, einen am Ende des Abluftkanals des Containers angeordneten Lüfter, und eine klimaabhängig arbeitende Steuereinrichtung für den Lüfter, wobei der außerhalb des Containers angeordnete Lüfter mit Wind und mit einem Elektromotor antreibbar ist und durch die Steuereinrichtung in Abhängigkeit von vorgegebenen Eingangsgrößen und den Klimaparametern innerhalb des Containers der elektromotorische Antrieb des Lüfters aktivierbar oder deaktivierbar ist und ein Öffnen, Schließen und/oder Verstellen der Zuluft- und Abluftklappen der Zu- und Abluftkanäle erfolgt, wobei der Steuereinrichtung neben den Klimaparametern als Eingangsgrößen mindestens zur Verfügung stehen die durch die vorhandene Windlast erzielbare Lüfterleistung oder Lüfterdrehzahl.

Dabei ist der Lüfter bevorzugt eine Hybridturbine, bei der die Windturbine selbst als zentrifugales elektromotorisch angetriebenes Gebläserad arbeitet.

In einer weiteren Ausgestaltung ist vorgesehen, dass die Steuereinrichtung mit einer autark arbeitenden Klimaanlage des Containers steuerungstechnisch verbunden ist, so dass die Klimaanlage zu- oder abschaltbar ist.

Weiterhin sieht die Ausgestaltung der Vorrichtung vor, dass die Steuereinrichtung mit Messdaten über die Außentemperatur über eine Eingabeeinrichtung versorgbar ist.

Um den Eintrag von Staub und Insekten in den Container zu verhindern, ist weiter vorgesehen, dass mindestens im Zuluftkanal ein Luftfilter angeordnet ist.

Das vorgeschlagene erfindungsgemäße Verfahren zur Kühlung des Innenraumes eines wärmeabstrahlende elektronische Bauelemente enthaltenen Containers, der aufweist einen Zuluftkanal für Umgebungsluft mit verstell- und verschließbarer Zuluftklappe, einen Abluftkanal in die Umgebungsluft mit verstell- und verschließbarer Abluftklappe, einen am Ende des Abluftkanals außerhalb des Containers angeordneten mit Wind und durch einen Elektromotor antreibbaren Lüfter, eine Steuerschaltung für den elektromotorischen Antriebes des Lüfters und zum Verstellen der Zu- und Abluftklappen sowie mindestens eine Eingabeeinrichtung für die Steuerschaltung sieht vor, dass die Steuereinrichtung durch vorgegebene Steuerbefehle und/oder durch einen Soll-Ist-Vergleich von gemessenen mit vorgegebenen Klimagrößen innerhalb des Containers aktiviert wird, die Steuereinrichtung in Abhängigkeit von dem Soll-Ist-Vergleich der Klimagrößen und der weiteren Eingangsgröße über die mit der vorhandenen Windlast erzielbaren Lüfterleistung oder Lüfterdrehzahl den elektromotorischen Lüfterantrieb zu oder abschaltet und eine Einstellung der Zu- und Abluftklappen vornimmt.

Der Lüfter, insbesondere in Form einer Hybridturbine, wird somit bei geöffneter Zu- und Abluftklappe durch den Wind angetrieben. Der Container wird durch die durchströmende Luft ohne Energiezufuhr gekühlt.

Beim Überschreiten mindestens eines vorgegebenen Klimaparameters innerhalb des Containers, vorzugsweise einer Innentemperatur, erfolgt ein Zuschalten des motorischen Lüfterantriebs, so dass die Durchsatzmenge an Kühlluft auch bei möglicherweise sinkender Windantriebskraft erhalten oder vergrößert wird.

Beim nachfolgenden weiteren Überschreiten eines vorgegebenen Klimaparameters innerhalb des Containers, vorzugsweise einer vorgegebenen Innentemperatur, trotz des zugeschalteten elektromotorischen Antriebs des Lüfters wird durch die Steuereinrichtung ein Alarmsignal ausgesendet.

Verfügt der Container noch über eine bis dahin ausgeschalteter Klimaanlage kann diese beim Überschreiten mindestens eines vorgegebenen Klimaparameters innerhalb des Containers, vorzugsweise einer vorgegebenen Innentemperatur, zugeschaltet werden, wobei der bis dahin aktivierte motorische Lüfterantrieb ausgeschaltet und die Zu- und Abluftklappen geschlossen werden. Die Kühlung erfolgt dann ausschließlich über die vorhandene Klimaanlage.

In analoger Weise erfolgt bei sinkender Innentemperatur oder einem anderen Klimaparameter das Abschalten der Klimaanlage, das Einschalten des elektromotorischen Antriebs mit Öffnen der Zu- und Abluftklappen sowie das Ausschalten des elektromotorischen Betriebs, wenn die Steuereinrichtung aufgrund der Eingangsdaten die energieökonomisch günstigste Kühlvariante berechnet hat.
Vorteilhafterweise wird dabei als weitere Eingangsgröße der Steuereinrichtung die gemessene Außentemperatur außerhalb des Containers zur Verarbeitung zugeleitet.

Weiter ermöglicht die vorgeschlagene Vorrichtung, dass beim Unterschreiten mindestens eines vorgegebenen Klimaparameters innerhalb des Containers, vorzugsweise einer Innentemperatur, zuerst die Zuluftklappe und bei einem weiteren Sinken der Temperatur auch die Abluftklappe verschlossen werden oder beide Klappen gleichzeitig. Ein solcher Fall deutet auf eine Störung hin, so dass beim Unterschreiten eines vorgegebenen Klimaparameters innerhalb des Containers, vorzugsweise einer vorgegebenen Innentemperatur, durch die Steuereinrichtung ebenfalls ein Alarmsignal ausgesendet wird.

Die Alarmauslösung kann in bekannter Weise durch eine Außenanzeige und/oder eine Signalübermittlung, auch funktechnisch, an eine Kontrollstelle erfolgen.

Die Vorrichtung soll anhand der Zeichnungen erläutert werden.

Es zeigen:
- Fig. 1: den zu kühlenden Container in einer Seitenansicht A und
- Fig. 2: den zu kühlenden Container in einer Seitenansicht B.

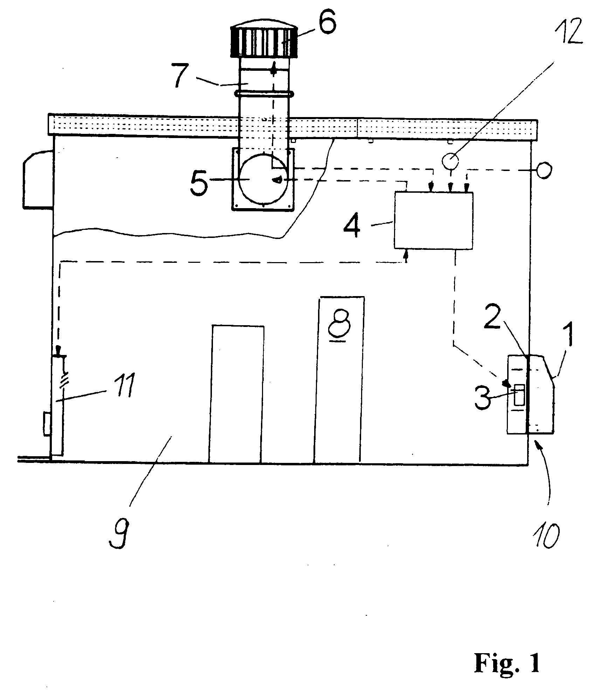

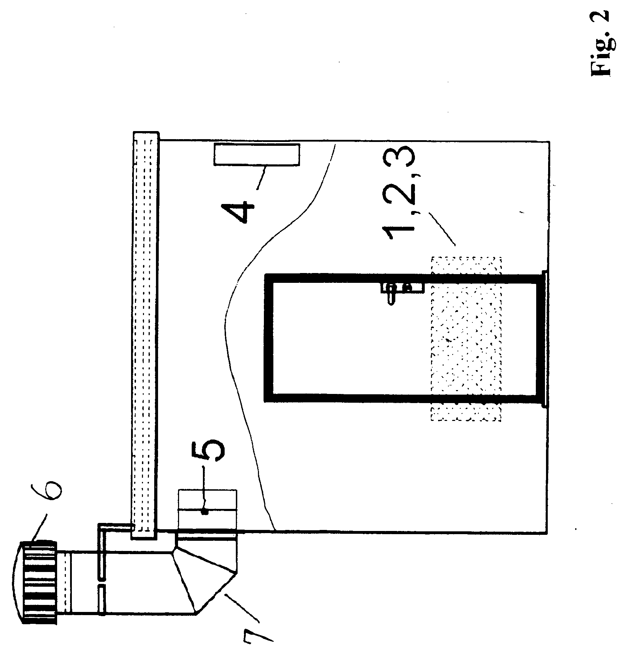

In den **Fig. 1** und **2** ist die Vorrichtung zum Kühlen von Telekommunikationsanlagen 8, die in Containern 9 angeordnet sind, dargestellt. Der Container 9 verfügt über einen verschließbaren Zuluftkanal 10 für Umgebungsluft in den Container 9, einen verschließbaren Abluftkanal 7 aus dem Container 9, einen am Ende des Abluftkanals 7 außerhalb des Containers 9 angeordneten Lüfter 6 in Form einer Hybridturbine, die mit Wind und zusätzlich einem Elektromotor antreibbar ist. Der Container 9 enthält weiter eine Steuereinrichtung 4, durch die in Abhängigkeit von vorgegebenen Eingangsgrößen und den Klimaparametern innerhalb des Containers 9 der elektromotorische Antrieb des Lüfters 6 aktivierbar oder deaktivierbar ist und durch die ein Öffnen, Schließen und/oder Verstellen der Zuluft- und Abluftklappen 3, 5 der Zu- und Abluftkanäle 7, 10 erfolgt. Als vorgegebene Eingangsgrößen stehen der Steuereinrichtung 4 neben den Klimaparameteren mindestens zur Verfügung die durch die vorhandene Windlast erzielbare Lüfterleistung oder Lüfterdrehzahl.

Ist eine autark betreibbare Klimaanlage 11 vorhanden, kann dies in den energieökonomischen Kühlprozess mittels der Hybridturbine einbezogen werden, indem die Steuereinrichtung 4 mit der Klimaanlage 11 des Containers 9 steuerungstechnisch verbunden wird, so dass die Klimaanlage zu- oder abschaltbar ist und damit verbunden die für den Betrieb der Klimaanlage notwendigen Bedingungen im Container 9 eingestellt werden.

Die Steuereinrichtung 4 ist weiter mindestens mit Messdaten über die Außentemperatur über eine Eingabeeinrichtung versorgbar.

Weiter wird gezeigt, dass mindestens im Zuluftkanal 10 ein Luftfilter 2 angeordnet ist.

Mit Inbetriebnahme der Elektronik 8 des Containers 9 beginnen die elektronischen Bauelemente Wärme abzustrahlen, was sich in einem Temperaturanstieg im Container 9, gemessen durch den Sensor 12, zeigt.

Die Steuereinrichtung 4 registriert diesen Temperaturanstieg (>15°C) und öffnet die Zu- und Abluftklappen 3 und 5. Der als Hybridturbine ausgebildete Lüfter 6 sorgt in Folge des Windantriebes für einen Kühlluftstrom aus der Umgebungsluft für eine Kühlung der Bauteile 8 (< 23°C). Wenn die Steuereinrichtung signalisiert, dass kein Wind zum Antrieb vorhanden ist, oder bei einem weiteren Temperaturanstieg (>23°C) wegen nicht ausreichender Kühlung, schaltet die Steuereinrichtung 4 den elektromotorischen Antrieb des Lüfters 6 zu oder an. Die Drehzahl kann dabei steuerbar sein.

Ergibt sich, dass die Kühlung nicht ausreichend ist - z. B. wegen zu hoher Außentemperaturen - schaltet die Steuereinrichtung bei Temperaturen um 30°C den elektromotorischen Antrieb des Lüfters 6 ab, schließt die Zu- und Abluftklappen 3 und 5 und aktiviert die Klimaanlage 11, die jetzt die Kühlung allein übernimmt. Ist keine Klimaanlage vorhanden oder steigt die Temperatur weiter, erfolgt eine Alarmsignalgebung.

Natürlich ist es auch möglich, unter Einbeziehung der Betriebsdaten sowie gemessener Umweltdaten den voraussichtlichen Temperaturverlauf zu berechnen und bei einer berechneten Gefahr zu einem früheren Zeitpunkt ein Alarmsignal auszusenden. Dies erfolgt gewöhnlich funktechnisch zu einer Zentrale.

Bei der Registrierung von sinkenden Innentemperaturen im Container 9 erfolgt der Vorgang umgekehrt.

Temperaturwerte unterhalb eines vorgegebenen niedrigen Wertes sollten ebenfalls zur Auslösung eines Alarmsignals führen, da dies auf eine möglich Betriebsstörung hinweist.

Natürlich ist es auch möglich, dem Vollzug der einzelnen Verfahrensschritte durch entsprechende Sensoren zu überwachen z. B. das Verschlossensein der Zu- und Abluftklappen 3 und 5. Auch dabei festgestellte Fehler können zu einer Alarmauslösung führen.

Berechnungen der Anmelderin haben ergeben, dass mit der vorgeschlagenen Anlage gegenüber der vorherrschenden Klimaanlagenkühlung pro Jahr 1.500 KW/h je Anlage eingespart werden und eine Reduktion des CO₂ Ausstoßes von 960 kg je Anlage erreicht wird. Angesichts von rund 8.000 Stationen in Deutschland ein enormer technischer Fortschritt.

### Bezugszeichenliste

- 1: Schutzgitter insbesondere Wetterschutz
- 2: Filter
- 3: Zuluftklappe mit Steuereinheit
- 4: Steuereinrichtung
- 5: Abluftklappe mit Steuereinheit
- 6: Lüfter
- 7: Abluftkanal
- 8: Elektronik
- 9: Container
- 10: Zuluftkanal
- 11: Klimaanlage
- 12: Sensor

## Patentansprüche

1. Vorrichtung zum Kühlen von gehausten Räumen, insbesondere von Telekommunikationsanlagen (8), die in Containern (9) angeordnet sind, mit einem verschließbaren Zuluftkanal (10) für Umgebungsluft in den Container (9),
einem verschließbaren Abluftkanal (7) aus dem Container (9),
einem am Ende des Abluftkanals (7) des Containers (9) angeordneten Lüfter (6),
und einer klimaabhängig arbeitenden Steuereinrichtung (4) für den Lüfter (6), **dadurch gekennzeichnet, dass**
der außerhalb des Containers (9) angeordnete Lüfter (6) mit Wind und mit einem Elektromotor antreibbar ist und
durch die Steuereinrichtung (4) in Abhängigkeit von vorgegebenen Eingangsgrößen und den Klimaparametern innerhalb des Containers (9) der elektromotorische Antrieb des Lüfters (6) aktivierbar oder deaktivierbar ist und ein Öffnen, Schließen und/oder Verstellen der Zuluft- und Abluftklappen (3, 5) der Zu- und Abluftkanäle (7, 10) erfolgt,
wobei der Steuereinrichtung (4) neben den Klimaparameteren als Eingangsgrößen mindestens zur Verfügung stehen die durch die vorhandene Windlast erzielbare Lüfterleistung oder Lüfterdrehzahl.

2. Vorrichtung nach Anspruch 1, **dadurch gekennzeichnet, dass**
der Lüfter (6) eine Hybridturbine ist, bei der die Windturbine selbst als zentrifugales elektromotorisch angetriebenes Gebläserad arbeitet.

3. Vorrichtung nach Anspruch 1 oder 2, **dadurch gekennzeichnet, dass**
die Steuereinrichtung (4) mit einer autark arbeitenden Klimaanlage (11) des Containers (9) steuerungstechnisch verbunden ist, so dass die Klimaanlage (11) zu- oder abschaltbar ist.

4. Vorrichtung nach einem der Ansprüche 1 bis 3, **dadurch gekennzeichnet, dass**
die Steuereinrichtung (4) mit Messdaten über die Außentemperatur über eine Eingabeeinrichtung versorgbar ist.

5. Vorrichtung nach einem der Ansprüche 1 bis 4, **dadurch gekennzeichnet, dass**
mindestens im Zuluftkanal (10) ein Luftfilter (2) angeordnet ist.

6. Verfahren zur Kühlung des Innenraumes eines wärmeabstrahlende elektronische Bauelemente enthaltenen Containers, der aufweist
einen Zuluftkanal für Umgebungsluft mit verstell- und verschließbarer Zuluftklappe,
einen Abluftkanal in die Umgebungsluft mit verstell- und verschließbarer Abluftklappe, einen am Ende des Abluftkanals außerhalb des Containers angeordneten mit Wind und durch einen Elektromotor antreibbaren Lüfter,
eine Steuerschaltung für den elektromotorischen Antrieb des Lüfters und zum Verstellen der Zu- und Abluftklappen sowie
mindestens einer Eingabeeinrichtung für die Steuerschaltung,
**dadurch gekennzeichnet, dass**
die Steuereinrichtung durch vorgegebene Steuerbefehle und/oder durch einen Soll-Ist-Vergleich von gemessenen mit vorgegebenen Klimagrößen innerhalb des Containers aktiviert wird,
die Steuereinrichtung in Abhängigkeit von dem Soll-Ist-Vergleich der Klimagrößen und der weiteren Eingangsgröße über die mit der vorhandenen Windlast erzielbaren Lüfterleistung oder Lüfterdrehzahl den elektromotorischen Lüfterantrieb zu oder abschaltet und eine Einstellung der Zu- und Abluftklappen vornimmt.

7. Verfahren nach Anspruch 6, **dadurch gekennzeichnet, dass**
der Steuereinrichtung die gemessene Außentemperatur außerhalb des Containers zur Verarbeitung zugeleitet wird.

8. Verfahren nach Anspruch 6 oder 7, **dadurch gekennzeichnet, dass**
beim Unterschreiten mindestens eines vorgegebenen Klimaparameters innerhalb des Containers, vorzugsweise einer Innentemperatur, zuerst die Zuluftklappe und bei einem weiteren Sinken der Temperatur auch die Abluftklappe verschlossen werden oder beide Klappen gleichzeitig.

9. Verfahren nach einem der Ansprüche 6 bis 8, **dadurch gekennzeichnet, dass**
beim Überschreiten mindestens eines vorgegebenen Klimaparameters innerhalb des Containers, vorzugsweise einer Innentemperatur, die Zu- und Abluftklappen geöffnet werden und bei einem weiteren Temperaturanstieg der motorische Lüfterantrieb zugeschaltet wird.

10. Verfahren nach einem der Ansprüche 6 bis 9, **dadurch gekennzeichnet, dass**
bei vorhandener ausgeschalteter Klimaanlage beim Überschreiten mindestens eines vorgegebenen Klimaparameters innerhalb des Containers, vorzugsweise einer vorgegebenen Innentemperatur, der bis dahin aktivierte motorische Lüfterantrieb ausgeschaltet und die Zu- und Abluftklappen geschlossen werden sowie die Klimaanlage aktiviert wird.

11. Verfahren nach einem der Ansprüche 6 bis 10, **dadurch gekennzeichnet, dass**
beim Überschreiten und/oder Unterschreiten eines vorgegebenen Klimaparameters innerhalb des Containers, vorzugsweise einer vorgegebenen Innentemperatur, durch die Steuereinrichtung ein Alarmsignal ausgesendet wird.

## Claims

1. A device for cooling enclosed spaces, in particular for telecommunication systems (8) that are arranged in containers (9), comprising
a closable air inlet channel (10) for ambient air into the container (9),
a closable air outlet channel (7) out of the container (9),
a fan (6) that is arranged at the end of the air outlet channel (7) of the container (9), and
a control device (4) for the fan (6), which control device functions in accordance with the climate,
**characterized in that**
the fan (6) that is arranged outside the container (9) can be driven by wind or by an electric motor, and
the electromotive drive of the fan (6) can be activated or deactivated by the control device (4) in accordance with predefined input values and the climate parameters inside the container (9), and the inlet and outlet air flaps (3, 5) of the inlet and outlet air channels (7, 10) are opened, closed and/or adjusted,
wherein the input values that are available to the control device (4), in addition to the climate parameters, include at least the fan output or fan speed that can be achieved due to the current wind load.

2. A device according to claim 1, **characterized in that**
the fan (6) is a hybrid turbine where the wind turbine itself functions as a centrifugal fan impeller that is driven by an electric motor.

3. A device according to claim 1 or 2, **characterized in that**
the control device (4) is connected to control an air conditioning (11) of the container (9), which air conditioning functions independently, so that said air conditioning (11) can be switched on or off.

4. A device according to any one of claims 1 to 3, **characterized in that**
the control device (4) can be supplied with measured outside temperature data by means of an input device.

5. A device according to any one of claims 1 to 4, **characterized in that**
an air filter (2) is arranged at least in the inlet air channel (10).

6. A method for cooling the interior of a container that contains heat-radiating electronic components and comprises
an air inlet channel for ambient air with an adjustable and closable inlet air flap,
an air outlet channel into the ambient air with an adjustable and closable outlet air flap,
a fan that is arranged at the end of the air outlet channel outside the container and can be driven by wind and by an electric motor,
a control circuit for the electromotive drive of the fan and for adjusting the inlet and outlet air flaps, and
at least one input device for the control circuit,
**characterized in that**
the control device is activated by means of predefined control commands and/or a target/actual comparison of measured to predefined climate values inside the container,
the control device switches the electromotive fan drive on or off using the fan output or fan speed that can be achieved due to the current wind load and adjusts the inlet and outlet air flaps, both in accordance with the target/actual comparison of the climate values and other input values.

7. A method according to claim 6, **characterized in that**
the outside temperature measured outside the container is supplied to the control device for processing.

8. A method according to claim 6 or 7, **characterized in that**
when at least one predefined climate parameter inside the container, preferably an inside temperature, falls below the predefined value, the inlet air flap is closed and if the temperature continues to fall, the outlet air flap is also closed, or both flaps are closed at the same time.

9. A method according to any one of claims 6 to 8, **characterized in that**
when at least one predefined climate parameter inside the container, preferably an inside temperature, rises above the predefined value, the inlet and outlet air flaps are opened and if the temperature continues to rise, the motor-driven fan drive is switched on.

10. A method according to any one of claims 6 to 9, **characterized in that**
if an air conditioning is provided but switched off while at least one predefined climate parameter inside the container, preferably a predefined inside temperature, rises above the predefined value, the motor-driven fan drive that has been activated so far is switched off, the inlet and outlet air flaps are closed and the air conditioning is activated.

11. A method according to any one of claims 6 to 10, **characterized in that**
when a predefined climate parameter inside the container, preferably a predefined inside temperature, rises above and/or falls below the predefined value, the control device emits an alarm signal.

## Revendications

1. Dispositif de refroidissement d'espaces enfermés, en particulier d'installations de télécommunication (8) disposées dans des conteneurs (9), comprenant
une gaine d'alimentation d'air fermable (10) pour introduire de l'air ambiante dans le conteneur (9),
une gaine d'évacuation d'air fermable(7) du conteneur (9), un ventilateur (6) disposé à l'extrémité de la gaine d'évacuation d'air (7) du conteneur (9),
et un dispositif de commande (4) pour le ventilateur (6) marchant en fonction du climat,
**caractérisé en ce que**
le ventilateur (6) disposé à l'extérieur du conteneur (9) peut être entraîné par le vent ou par un moteur électrique, et
l'entraînement par moteur électrique du ventilateur (6) peut être activé ou désactivé par le dispositif de commande (4) en fonction des valeurs d'entrée prédéfinies et des paramètres climatiques à l'intérieur du conteneur (9), et une ouverture, une fermeture et/ou un réglage des clapets d'alimentation d'air et d'évacuation d'air (3, 5) des gaines d'alimentation et d'évacuation d'air (7, 10) est effectué,
dans lequel, à part les paramètres climatiques, au moins la puissance du ventilateur ou le nombre de tours du ventilateur réalisables par la charge du au vent existante sont à la disposition du dispositif de commande (4) en tant que valeurs d'entrée.

2. Dispositif selon la revendication 1,
**caractérisé en ce que**
le ventilateur (6) est une turbine hybride, dans laquelle la turbine éolienne elle-même fonctionne en tant que roue soufflante centrifuge à entraînement par moteur électrique.

3. Dispositif selon la revendication 1 ou 2,
**caractérisé en ce que**
le dispositif de commande (4) est lié à une installation de climatisation (11) du conteneur (9) fonctionnant indépendamment, de telle manière que l'installation de climatisation (11) peut être mise en ou hors circuit.

4. Dispositif selon l'une des revendications 1 à 3,
**caractérisé en ce que**
le dispositif de commande (4) peut être alimenté en données de mesure sur la température extérieur par l'intermédiaire d'un dispositif d'entrée.

5. Dispositif selon l'une des revendications 1 à 4,
**caractérisé en ce que**
un filtre à air (2) est disposé au moins dans la gaine d'alimentation d'air (10).

6. Procédé de refroidissement de l'intérieur d'un conteneur contenant des composants électroniques émettant de la chaleur, comprenant
une gaine d'alimentation d'air pour air ambiante avec un clapet d'alimentation d'air réglable et fermable,
une gaine d'évacuation d'air dans l'air ambiante avec un clapet d'évacuation d'air réglable et fermable,
un ventilateur disposé à l'extrémité de la gaine d'évacuation d'air à l'extérieur du conteneur et pouvant être entraîné par le vent et par un moteur électrique, un circuit de commande pour l'entraînement par moteur électrique du ventilateur et pour régler les clapets d'alimentation et d'évacuation d'air, et
au moins un dispositif d'entrée pour le circuit de commande,
**caractérisé en ce que**
le dispositif de commande est activé par des instructions de commande prédéfinies et/ou une comparaison valeur consigne/valeur réelle entre les valeurs climatiques mesurées et prédéfinies à l'intérieur du conteneur,
le dispositif de commande met en ou hors circuit l'entraînement par moteur électrique du ventilateur en fonction de la comparaison valeur consigne/valeur réelle des valeurs climatiques et des autres valeurs d'entrée par l'intermédiaire de la puissance du ventilateur ou du nombre de tours du ventilateur réalisables par la charge du au vent existante, et effectue un réglage des clapets d'alimentation et d'évacuation d'air.

7. Procédé selon la revendication 6,
**caractérisé en ce que**
la température extérieure mesurée à l'extérieur du conteneur est transmise au dispositif de commande pour traitement.

8. Procédé selon la revendication 6 ou 7,
**caractérisé en ce que**
lorsque au moins un paramètre climatique à l'intérieur du containeur, de préférence une température intérieure, descend au-dessous de la valeur prédéfinie, d'abord le clapet d'alimentation d'air et, en cas d'une baisse continue de la température, aussi le clapet d'évacuation d'air est fermé ou les deux clapets en même temps.

9. Procédé selon l'une des revendications 6 à 8,
**caractérisé en ce que**
lorsque au moins un paramètre climatique à l'intérieur du containeur, de préférence une température intérieure, dépasse la valeur prédéfinie, les clapets d'alimentation et d'évacuation d'air sont ouverts et, en cas d'une hausse continue de la température, l'entraînement par moteur du ventilateur est mise en circuit.

10. Procédé selon l'une des revendications 6 à 9,
**caractérisé en ce que**
lorsque, en présence d'installation de climatisation arrêtée, au moins un paramètre climatique à l'intérieur du containeur, de préférence une température intérieure prédéfinie, dépasse la valeur prédéfinie, l' entraînement par moteur du ventilateur jusque-là activé est mis hors circuit, les clapets d'alimentation et d'évacuation d'air sont fermés et l'installation de climatisation est activée.

11. Procédé selon l'une des revendications 6 à 10,
**caractérisé en ce que**
lorsque un paramètre climatique à l'intérieur du containeur, de préférence une température intérieure prédéfinie, dépasse et/ou descend au-dessous de la valeur prédéfinie, un signal d'alarme est émis par le dispositif de commande.
